**Europäisches Patentamt**

**European Patent Office**

**Office européen des brevets**

(11) Publication number: **0 190 053**
**B1**

(12) # EUROPEAN PATENT SPECIFICATION

(45) Date of publication of patent specification: **24.05.89**

(21) Application number: **86300650.8**

(22) Date of filing: **30.01.86**

(51) Int. Cl.⁴: **G 01 R 11/14, G 01 R 11/10**

(54) Watthour meter with a shielded magnetic bearing.

(30) Priority: **30.01.85 JP 17803/85**

(43) Date of publication of application:
**06.08.86 Bulletin 86/32**

(45) Publication of the grant of the patent:
**24.05.89 Bulletin 89/21**

(84) Designated Contracting States:
**CH DE GB LI**

(56) References cited:
**DE-A-2 626 044**
**DE-A-2 804 347**
**FR-A-2 022 608**

(73) Proprietor: **MITSUBISHI DENKI KABUSHIKI KAISHA**
**2-3, Marunouchi 2-chome Chiyoda-ku**
**Tokyo 100 (JP)**

(72) Inventor: **Senoo, Kanemasa c/o Fukuyama Works**
**Mitsubishi Denki K.K. 1-8, Midori-machi**
**Fukuyama City Hiroshima Pref. (JP)**
Inventor: **Takeshita, Shigeki c/o Fukuyama Works**
**Mitsubishi Denki K.K. 1-8, Midori-machi**
**Fukuyama City Hiroshima Pref. (JP)**

(74) Representative: **Lawson, David Glynne et al**
**MARKS & CLERK 57-60 Lincoln's Inn Fields**
**London WC2A 3LS (GB)**

## Description

### Background of the invention

This invention relates to a watthour meter and more particularly to improvements in various characteristics under light load condition.

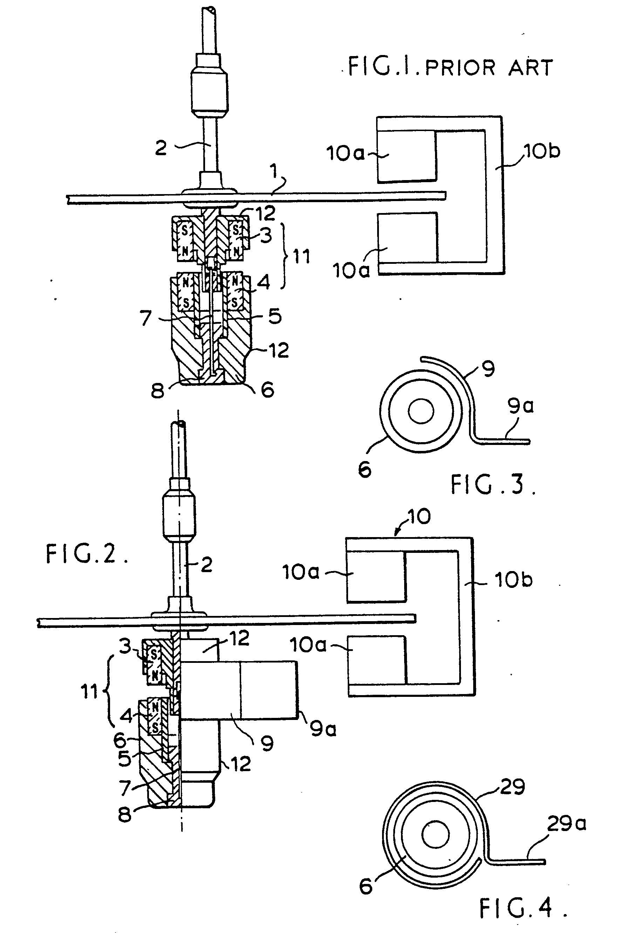

Figure 1 is a cross sectional view illustrating a magnetic bearing of a conventional watthour meter disclosed in Japanese Utility Model Publication No. 50—23694. In the figure, a rotatable disc 1 of the watthour meter is fixed to a rotatable shaft 2 which is rotatably supported from an unillustrated frame of the watthour meter. The lower end of the rotatable shaft 2 is supported by a magnetic bearing 12 which comprises a pair of bearing magnets 11; i.e., a rotatable magnet 3 and a fixed magnet 4 arranged in opposite polarities. The rotatable magnet 3 comprises a ferromagnetic material magnet of a cylindrical shape and is fixed to the rotatable shaft 2. The fixed magnet 4 comprises a magnet of ferromagnetic material of a cylindrical shape fixed to a housing 6. A temperature compensating magnetically permeable alloy of cylindrical shape is mounted within the inner peripheral portion of the fixed magnet 4. The magnetic bearing 12 further comprises a guide pin 7, and a bush 8 that is fixed to the housing 6. Thus, the rotatable disc 1 is supported by the magnetic repulsive force between the rotatable magnet 3 and the fixed magnet 4.

As is well known, conventional watthour meters, further comprise a driving device (not shown) and a braking device 10 for driving and braking, respectively, the disc 1. The braking device 10 comprises a pair of braking magnets 10a made of permanent magnets and a yoke 10b for mounting these magnets 10a. The braking torque of the braking device 10 given to the rotatable disc 1 is dependent on the position of the braking magnets 10a relative to the rotatable disc 1. Generally, when the center of the poles of the magnets 10a is positioned to 70—80% of the radius of the disc 1 from its center, maximum braking torque is obtained. So the braking magnets 10a are usually disposed in this position.

As a predetermined rotating driving torque is applied to the rotatable disc 1 by the driving device (not shown) including a voltage circuit and a current electromagnet, the rotatable disc 1, which is rotatably supported by the electromagnetic repulsive force between the rotatable magnet 3 and the fixed magnet 4, rotates in a predetermined direction. Braking torque is also applied to the disc 1 by the braking device 10 in order to ensure that the rotatable disc 1 rotates precisely in accordance with power consumption.

While the braking device is constructed to prevent leakage of the magnetic flux from the magnets, it is not possible to make the flux leakage from the braking device zero. Therefore, the leakage flux from the braking device may interfere with the magnetic flux from the magnetic bearing. This results in an undesirable rotating torque which causes the disc to rotate even during non-load conditions. The leakage flux from the braking device also makes the magnetic bearing unreliable. Electrical shielding around the magnetic bearing of a watthour meter is known from DE—A—2804347.

### Summary of the invention

Accordingly, an object of the present invention is to eliminate the above-discussed disadvantages of conventional watthour meters.

Another object of this invention is to provide a watthour meter in which the leakage flux from the braking device does not undesirably affect the magnetic bearing.

With the above objects in view, the watthour meter of this invention comprises a magnetic bearing having a pair of magnets for rotatably supporting a rotatable disc, and a braking device having a braking magnet disposed for applying braking torque to the rotatable disc. The watthour meter further comprises a magnetic shield disposed between the magnetic bearing and the braking device for preventing leakage flux from the braking device from interfering with the magnetic flux of the magnetic bearing.

### Brief description of the drawings

Figure 1 is a partial sectional front view of the main portion of a conventional watthour meter.

Figure 2 is a partial sectional front view of a watthour meter of this invention, a certain portion thereof illustrated by a cross-sectional view.

Figure 3 is a bottom view of Figure 2 showing the magnetic shield of the present invention relative to the bearing; and

Figure 4 is a bottom view similar to Figure 2 showing another embodiment of the invention.

### Preferred embodiments of the invention

Referring to Figures 2 and 3, an embodiment of this invention will be described. In the drawings, the same symbols as those used in connection with Figure 1 represent identical or corresponding portions. Figure 3 is a bottom view thereof. By comparing Figures 2 and 3 with Figure 1, it is readily understood that the watthour meter of the present invention is different from the watthour meter shown in Figure 1 in that the former is provided with a magnetic shield 9 disposed between the braking magnets 10a and the magnetic bearing 12. The magnetic shield 9 is made of a magnetic material and partly surrounds the magnetic bearing 12 so that the gap between the bearing magnets 3 and 4 is shielded against the leakage flux from the braking magnets 10a. The magnetic shield 9 may be attached to a frame structure (not shown) of the meter by a tab 9a.

According to the present invention, the magnetic flux leakage from the braking magnets 10a is shielded by the magnetic shield 9 so that it does not interfere with the magnetic flux of the bearing 12. Therefore, the magnetic bearing 12 supports the rotary disc 1 at a prescribed constant position.

Furthermore, while the magnetic shield 9 of the above embodiment only partially surrounds the bearing magnets against the leakage flux from the braking device, the magnetic shield of the present invention may completely surround the bearing magnets as illustrated by a tubular magnetic shield 29 shown in Figure 4. With this arrangement, the magnetic bearing 12 is protected not only against the leakage flux from the braking magnets 10a but also against any undesirable magnetic flux from some exterior source including that from a magnet for tampering with the meter.

## Claims

1. A watthour meter comprising:
a magnetic bearing (12) having a pair of magnets (3, 4) for rotatably supporting a rotatable disc (1) and
a braking device (10) having a braking magnet (10a) of unvarying polarity for applying a braking torque to said rotatable disc, characterized by having a magnetic shield (9) disposed between said magnetic bearing and said braking device for preventing leakage flux from said braking device from interfering with the magnetic flux of said magnetic bearing.

2. A watthour meter as claimed in claim 1 wherein said magnetic shield is disposed partially around the periphery of said magnetic bearing on the side nearest said braking device and spaced between said braking device and said magnetic bearing.

3. A watthour meter as claimed in claim 1 wherein said magnetic shield is disposed around the whole periphery of said magnetic bearing and spaced between said braking device and said magnetic bearing.

## Patentansprüche

1. Wattstundenzähler, umfassend
—ein Magnetlager (12) mit einem Paar von Magneten (3, 4), um eine drehbare Scheibe (1) drehbar zu lagern, und
—eine Bremseinrichtung (10) mit einem Bremsmagneten (10) von unveränderlicher Polarität, um ein Bremsdrehmoment auf die drehbare Scheibe einwirken zu lassen, gekennzeichnet durch eine Magnetabschirmung (9), die zwischen dem Magnetlager und der Bremseinrichtung angeordnet ist, um zu verhindern, daß ein magnetischer Strefluß von der Bremseinrichtung den Magnetfluß des Magnetlagers stört.

2. Wattstundenzähler nach Anspruch 1, wobei die Magnetabschirmung teilweise um den Umfang des Magnetlagers herum auf der Seite, die der Bremseinrichtung am nächsten liegt, und beabstandet zwischen der Bremseinrichtung und dem Magnetlager angeordnet ist.

3. Wattstundenzähler nach Anspruch 1, wobei die Magnetabschirmung um den gesamten Umfang des Magnetlagers herum und beabstandet zwischen der Bremseinrichtung und dem Magnetlager angeordnet ist.

## Revendications

1. Watt-heuremètre comportant:
un palier magnétique (12) comportant une paire d'aimants (3, 4) pour supporter en rotation un disque rotatif (1) et
un dispositif de freinage (10) comportant un aimant de freinage (10a) de polarité invariable pour appliquer un couple de freinage au disque rotatif, caractérisé en ce qu'il est pourvu d'un écran magnétique (9), disposé entre le palier magnétique et le dispositif de freinage pour empêcher que le flux de fuite du dispositif de freinage d'intefère avec le flux magnétique du palier magnétique.

2. Watt-heuremètre selon la revendication 1, où l'écran magnétique est disposé partiellement autour de la périphérie du palier magnétique, sur le côté le plus proche du dispositif de freinage, en étant positionné entre le dispositif de freinage et le palier magnétique.

3. Watt-heuremètre selon la revendication 1, où l'écran magnétique est disposé autour de la totalité de la périphérie du palier magnétique, en étant positionné entre le dispositif de freinage et le palier magnétique.

FIG.1. PRIOR ART

FIG.2.

FIG.3.

FIG.4.